# EUROPEAN PATENT SPECIFICATION

(11) **EP 1 815 541 B1**
(45) Date of publication and mention of the grant of the patent: **27.07.2011**
(21) Application number: 05799476.6
(22) Date of filing: 04.11.2005
(51) Int. Cl.: H01L 51/05

(54) **SELF-ALIGNED PROCESS TO MANUFACTURE ORGANIC TRANSISTORS**
SELBSTAUSGERICHTETES VERFAHREN ZUR HERSTELLUNG ORGANISCHER TRANSISTOREN
PROCESSUS AUTO-ALIGNE PERMETTANT DE PRODUIRE DES TRANSISTORS ORGANIQUES

(30) Priority: 09.11.2004 US 626399 P
(43) Date of publication of application: 08.08.2007
(73) Proprietor: Creator Technology B.V., 4837 BN Breda (NL)
(72) Inventor: GELINCK, Gerwin, H., NL-5621 BA Eindhoven (NL); DUINEVELD, Paulus, C., NL-5621 BA Eindhoven (NL)
(74) Representative: Goddar, Heinz J.
(86) International application number: PCT/IB2005/053606
(87) International publication number: WO 2006/051457

(56) References cited:
- WO-A-03/083960
- WO-A-2005/069402
- US-A1- 2003 059 984
- US-A1- 2003 085 398
- US-A1- 2003 230 747

## Description

The present invention relates to a structure of a semiconducting device and method of manufacturing a semiconducting device, in particular, to a structure of thin film transistors and method of manufacturing a device including a number of thin film transistors.

In recent years, semiconductor based displays such as thin film transistor, (TFT) displays have become increasingly widespread. TFTs form basic elements of microelectronic circuits, and typically consist of a number of discrete layers, formed from insulating, semiconductor or electrically conducting material.

Some organic materials, such as, for example, pentacene, polythiophene, polyfluorene, polyphenylenevinylene, and triphenylamines may exhibit semiconductor properties. Semiconducting components, arrangements, and circuits comprising organic semiconductors promise a number of advantages over traditional semiconductor based structures. These advantages include ease of processing, e.g. solution processing, as well as mechanical flexibility. Microelectronics based on solution-processed organic semiconductors may, for example, be used in simple circuitry such as flexible displays and identification tags. Recently, considerable research has been undertaken in the field of organic semiconductors and manufacturing of semiconductor components and circuits based on organic semiconductors, including, in particular, semiconductor structures and manufacturing methods for semiconductor structures for displays.

A semiconductor based display or other semiconducting device may have as a substrate, a flexible and less expensive plastic instead of glass. The flexible substrate may be, for example, a polymer foil. Using a polymer substrate, however, limits processing temperature during manufacture to about 200°C. The temperature is preferably kept lower than 150°C.

One method for manufacturing an organic semiconductor based display includes applying the organic transistors of the display by spin coating. A disadvantage of this technology is that a uniform layer of semiconducting material is applied, requiring a separate patterning process. Furthermore, spincoating is rather inefficient from a cost point of view as most of the material ends up in the spincoater bowl and not on the substrate.

Printing is another low temperature process and may be used instead of spincoating such organic semiconductor materials. An often preferred method of applying the polymer is by use of printing processes, such as ink-jet printing, whereby the semi-conducting organic material may be deposited locally. The surface on which the material is to be printed is often pre-treated, in order to prevent the polymer from spreading over large area.

Printing methods, such as "drop-on-demand" type inkjet processes, are currently being developed for this application, because they inherently offer more flexibility in manufacturing and may therefore have significant advantages. An organic semiconductor material used in one of these devices may be, for example, a PPV (polyphenylene-vinylene). Printing of PPV's for electroluminescent (polymer light-emitting diode or "polyLED") displays has been done experimentally as has ink-jet printing of multiple polymer layers, for example, a polyethylenedioxythiophene (PEDOT)-PPV stack. The dry polymer layer thickness can be 100-200 nm for the PEDOT layer and 50-100 nm for the light-emitting PPV layer. Layers can be printed without pinholes. Further, layer thickness variations of 5% or less have been achieved.

Non-prepublished application WO IB 2004/050669, filed May 13, 2004, discloses resist structures of particular shapes which are used, in particular, in connection with an ink-jet printing process. To simplify the ink-jet printing, i.e. to keep the ink-jet printed liquid in the desired areas, the structure on which the liquid is printed typically comprises a resist structure, which prevents the printed liquid from spreading to unwanted areas.

Non-prepublished application WO IB 2004/051170, filed July 8, 2004 relating to a modification of substrate properties for inkjet printing on plastic, discloses ink-jet printing in sub-areas defined by barriers and a thin-film patterning arrangement in which barriers partition a surface of a substrate.

Dimensional instability of polymer foils also imposes problems, in particular in combination with the use of rigid photomasks.

US2003/0230747 describes a method wherein grooves in a desired circuit configuration are formed in the surface of a substrate to pre-pattern the area to receive material forming an organic thin film transistor (OTFT) structure and interconnecting conductive paths. The OTFT material is deposited in the pre-patterned area using printing techniques such as ink jet printing.

US2003/0085398 describes an organic semiconductor device that has an organic semiconductors layer disposed within a depression formed in a substrate; a drain electrode and a source electrode; and a gate electrode to face the organic semiconductor layer with a gate insulating layer interposed.

Application publication no. WO 01/47045 A1 of Henning Sirringhaus et al., published June 28, 2001, discloses a method for fabricating all-polymer transistors and methods to integrate these transistors into a circuit. Patterns of narrow, hydrophobic surface regions are used to confine the spreading of water-based conducting polymer ink droplets. 50 nm high polyimide features define critical device dimensions. Besides the geometrical confinement, use is also made of the difference in wetting between the hydrophobic (polyimide) features and the hydrophilic substrate. Conducting patterns of fine features are created that can be used as source and drain electrodes in a transistor configuration. In later steps, semiconductor and insulator are spin coated. In a final step in the fabrication, the gate electrode (plus interconnect line) are made from a conducting polymer that is again deposited in a layer by printing.

The method disclosed in WO 01/47045 A1 is not a self-aligned process. Registration (alignment of a pattern in a next layer with respect to features on the patterned substrate) is absent, or done separately for every layer. Furthermore, the sheet conductivity achieved for the conducting polymer is too low to be used for displays, in particular larger displays, which require low-ohmic column and row lines. Use of thicker polyimide features is not permitted by the structure disclosed in WO 01/47045 A1, since significantly thicker polyimide features cannot be accommodated in the geometry disclosed. Thicker polyimide features in the invention of WO 01/47045 A1 would lead to a topology that degrades the transistor performance.

One of the main challenges now is, moreover, the integration of the organic transistors using a cost-effective fabrication process. For that purpose it is advantageous to deposit many layers, not just the semiconductor, from solution by, for instance, inkjet printing.

In many devices all layers are patterned using relatively expensive lithographic techniques. Other disadvantages of photolithography are difficulty in patterning non-planar surfaces and limitation to work with photosensitive resists. To control cost and simplify fabrication, the number of lithographic steps should be kept to a minimum.

Spincoating as deposition technique has similar disadvantages with regard to cost. With spincoating only a minute fraction of the polymer dissolved ends up in the final component. More than 99% of the material ends up as waste during either deposition or patterning. This problem is particularly significant as the materials costs of (semi)conducting polymers constitute a large part of the total manufacturing cost, and the price level of these materials is expected to remain relatively high. It is therefore necessary to limit the usage of materials to a minimum (and also reduce chemical waste).

Another problem with regard to organic semiconductors is that processing of the source-drain layer takes place between deposition of the insulator and deposition of semiconductor layers. This is different from the usual procedure for amorphous silicon transistors, where transistors with the highest mobility and least hysteresis are obtained when the insulator and semiconductor layers are deposited in one continuous process.

Another problem is that a large alignment tolerance is required, especially when using a plastic substrate that shrinks or expands during processing. Hence, it is highly favorable when more than one layer can be formed in one pre-defined region rather than defining the patterning for every separate layer, as this will increase the required alignment tolerance of the design.

Accordingly, the invention preferably seeks to limit or eliminate one or more of the above mentioned disadvantages, singly or in any combination.

The present invention relates to a method of manufacturing an organic semiconductor device as defined in claim 1 in which a hybrid combination of inkjet printing techniques and photolithographic steps avoids use of relatively expensive lithographic techniques.

In one embodiment of the present invention, the extent of the structure of an organic semiconductor which must be applied by lithography is reduced.

In another embodiment, the invention relates to a method of manufacturing an organic semiconducting device which reduces the number of photolithographical masks required, while avoiding the presence of semiconductor between conductive layers in a crossing and the accompanying leakage currents.

In another aspect, the invention relates to a method of manufacturing an organic semiconductor device in which the amount of polymer material required is reduced.

In one embodiment, the deposition of layers by spin coating is avoided.

In another embodiment the number of layers deposited by spincoating is reduced.

In another aspect, the invention relates to a method of manufacturing an organic semiconductor device in which deposition of insulator and semiconductor layers is in one step.

In another aspect, the invention relates to a method of manufacture of an organic semiconducting device with a top gate structure, in which the semiconductor is protected by the insulator on top.

In another aspect, the invention relates to a method of positioning a first layer of a semiconducting device with respect to a second layer in which more than one layer is formed in a predefined region.

Furthermore, the invention relates to a semiconducting device in which accurate positioning with respect to a first layer is only required for one layer (a resist structure) instead of four layers. The structure of the present invention in which a cavity is formed on a substrate and first layer of a first conducting material in a pattern of source and drain electrodes, inherently locates semiconductor with respect to insulator; and insulator with respect to gate electrode. An alignment tolerant design with small overlaps is made possible.

In another aspect, the invention relates to a structure for and method of reducing the stress in layers of a semiconductor device and consequently the chance of cracks and film peeling.

In one embodiment, stress in the layers is reduced by removing an insulator layer everywhere, except in transistors and in crossings.

In another embodiment, the invention relates to a semiconducting device in which different components of a circuit or display form separate islands on a substrate. Removal of the insulator layer, semiconductor layer and metal layers in the other areas of the substrate reduces the stress, and consequently the chance of cracks and film peeling, and increases the mechanical flexibility of the device.

In another aspect, crossings between first and second metallic interconnect lines are electrically isolated from each other by a (thicker) layer of the resist structures, rather than by the gate insulator.

These and other aspects of the invention will be apparent from and elucidated with reference to the embodiment(s) described hereinafter.

In the drawings:
**FIG. 1** is a schematic of an organic thin film transistor;
**FIG. 2** shows a sequence in which thin a film transistor is built-up on a substrate; and
**FIG. 3** shows a top view of a thin film transistor pixel.

The following description focuses on an embodiment of the invention applicable to an organic semiconductor structure. It will, however, be appreciated by one of skill in the art that the invention is not limited to this application but may be applied to many other semiconductor arrangements.

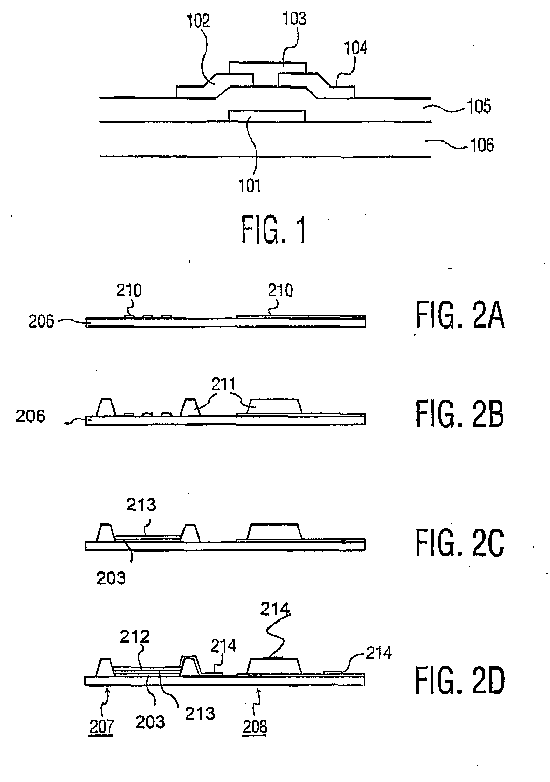

A typical organic thin film transistor with a bottom-gate device architecture is shown in **FIG. 1**. Typically, organic thin film transistors are made by standard photolithographic methods. The TFTs are formed on a substrate 106 which is typically a polymer, for example, a 25 µm polyethylene naphthalate (PEN) film.

Four mask steps are necessary. First the gate layer (usually a metal layer, for example gold) is deposited and patterned by photolithography to form the gate **101** electrodes. Then the insulator layer **105** (for example, a layer of a polymer such as the commercially available novolacs) is deposited and patterned in order to make holes for vertical interconnects. The third layer deposited is the source-drain layer (gold or a conductive polymer such as PEDOT (poly (3,4-ethylene dioxythiophene)) or PANI (polyaniline)) that is patterned to form the source **102** and the drain **104** of the transistor. Finally, a semiconductor **103** is deposited (polythienylene vinylene, polyvinylenephenylene, polyarylamines, polythiophene or oligoacenes, for example). Structuring of the semiconductor **103** requires a fourth mask step. The gate-source and gate-drain overlap is typically 5 µm, which is the same size as commonly used for the channel length (i.e. the gap between the source and the drain).

The gate-source and gate-drain overlap forms parasitic capacitance that affect the value of the kickback voltage in active-matrix displays and the switching speed of integrated circuits. It is not possible to remove the overlap, as there is a certain alignment tolerance required between the two conductive layers (usually about this 5 µm value). Particularly, variation in kickback voltage between different TFTs is detrimental for operation of a display.

**FIG. 2** illustrates an embodiment of the hybrid combination of inkjet printing and photolithographic steps of the present invention.

Processing starts **(1)** by depositing on a substrate **206** and patterning a first layer of conducting material that forms the first interconnect metal layer, and source-drain electrodes **210**. The way this layer is deposited as well as the type of material used can be chosen freely as long as feature sizes in the order of 5 µm are achieved; the material provides a good injecting contact into the semiconductor; and sheet conductivity specifications are met. For large active-matrix displays the latter typically leads to the use of metals. It is preferred that the source and drain electrodes are provided as a pair of interdigitated electrodes.

Then, a resist pattern **211** is made forming barriers and cavities as shown in line **(2)** of **FIG. 2**.

Barriers are protruding members deposited on a surface of the substrate. Barriers may be used to form discrete structures which define thin film patterns on sub-areas of the surface. These sub-areas enclosed or partially enclosed in two dimensions are referred to as cavities. The liquids comprising the thin film materials are deposited on the different sub-areas. For example, structures formed by cavities on the substrate surface may be used to define the transistors. The cavity in the embodiment shown in **FIG. 2** is separate, and does not have a common wall with another cavity. The cavities of the present invention may, however, share walls. Barriers may be arranged to form a regular array of generally square cavities, an array of cavities with curved walls or any other repetition pattern, depending, for example, on a desired number of pixels per unit of area. The partitioning barriers are generally photoresists of organic material, the patterns of which, typically, have been defined by lithography. In some sub-areas barriers may serve as a dielectric that isolates first and second metal layers. A desired pattern can be made in various ways, e.g. photolithography, embossing, or material transfer. Cavities are used to define the active areas of TFTs **207**, and can have many shapes. Walls of the cavities may be concave or curved. Cavities may have rounded edges or rounded corners.

Barriers are used as insulator layer on crossings **208** of first and second interconnect lines A barrier has preferably a thickness in the order of 2-5 µm. Barriers at crossings of a first conductor in the first conductor layer and a second conductor in the second conductor layer provide insulation and keep a minimum distance between the conductors.

The ends of the interdigitated source and drain electrodes extend outside the cavity, to avoid spatial variation in source-gate and drain-gate capacitances.

The resist structure is preferably made of a polymer material and the solution containing the organic semiconductor is preferably of an organic semiconductor or conductor. The resist used may be any of a number of commercially available photoresists, based on, for example, polyvinylphenol (UVN5 Shipley), novolac (HPR504, Olin Hunt), isoprene (SC100 Olin Hunt), epoxy (XP SU8, Microresist Technologies), or benzocyclobutene (Dow Chemical).

The next step may be a surface treatment to make a contrast in wettability between the substrate and the barrier material. Wettability refers to the tendency of a surface to allow a layer of a substance to form, rather than allowing formation of droplets of a spherical or other shape. For example, for the surface treatment, an oxygen plasma (or UV-ozone treatment or argon plasma) may first be applied to increase the wettability of the substrate. Then a fluor plasma, such as a CF₄ or CHF₃ or SF₆ plasma, may be applied to decrease the wettabilty of the barrier material, while the wettability of the substrate is not (or not significantly) decreased by application of the CF₄ or CHF₃ or SF₆ plasma. A treatment of this kind is effective if the barrier is an organic material, such as a photopolymer and the substrate is (at least partially) inorganic, for example, when a glass substrate is used. For a plastic substrate results can be problematic, as the substrate is not inorganic. Therefore a very thin (partially) inorganic coating can be applied on the plastic substrate. A thin film patterning arrangement and a method or producing such an arrangement are disclosed in the non-prepublished application no. WO IB 2004/051170, filed July 8, 2004.

This surface treatment is useful for preventing printed material from wetting the barriers in the present invention. The surface treatment disclosed in WO IB 2004/051170 does not adversely affect the transistor characteristics and may be used without any negative effect on the device efficiency.

Surface treatment may be applied after deposition of each layer.

Cavities are subsequently be filled as shown in Fig. 2C with a solution containing the soluble semiconductor **203** to give a 100-200 nm thick film after drying.

Suitable soluble semiconductors include all kinds of organic semiconductors, and in principle also inorganic. semiconductors Suitable organic semiconductors include the PPVs, the polythienylene-vinylenes, polyfluorenes, blends of carrier materials and oligomers, (particularly pentacene and rubrene), polyarylamines, polythiophenes, and the like, copolymers of oligomers and non-semiconducting monomers. These organic semiconductors may include any side-chains (alkyl-, alkoxygroups in particular but not exclusively) as is known to the skilled person in the art.

The deposition of the solution containing the semiconductor **203** and subsequent layers is preferably by a printing process but it is within the contemplation of the invention that any suitable process may be used. The printing may, for example, be by drop-on-demand ink jet printing (which may e.g. be bubble jet or piezo electric printing), continuous ink-jet printing, screen printing, flexographic printing, micro contact printing or micro-molding in capillaries (MIMIC) may be used advantageously, instead of lithography, for deposition of layers in the cavity.

The organic semiconductor may be applied as a precursor. The use of a precursor molecule is a well-known technique in the field. The precursor may be converted in the semiconductor material after its deposition.

Cavities are filled with a solution containing the soluble gate insulator **213**. After drying the layer will be 50-400 nm thick, and, preferably, as thin as possible provided the layer is still free of pinholes, and the layer thickness is sufficiently uniform.

Suitable gate dielectrics include all organic insulators, and, in principle, inorganic insulators. Suitable organic insulators include, in particular, polyvinylphenol, novolac-based polymers, epoxy-based polymers, polyisoprenes, polymethylmethacrylate (PMMA), poly(m-xylene adipamide), polyamide, polyvinylidenedifluoride and its copolymers poly(vinylidene fluoride/trifluoroethylene).

Cavities are then filled with a solution containing a soluble polymer conductor, such as poly (3,4-ethylene dioxythiophene) stabilized with polystyrenesulfonic acid (PEDOT-PSS). After drying this layer containing the gate electrodes **212** will be at least 50 nm thick.

A second layer **214** of interconnect lines is deposited and patterned. The material and patterning technique are chosen on the basis of conductivity specifications and design rules (minimum feature size).

Special care should be taken to avoid problems with step coverage and assure continuous interconnect lines on the substrate. Barriers may have a concave shape which gives a very good coverage of the evaporated metal, but other shapes may also be possible. A mushroom or umbrella shaped resist structure is to be avoided. Among the possible measures that can be taken are tapered edges at the resist patterns used to form the cavity and barriers; using a deposition tool with a planetarium; sputtering in the presence of argon. Preferably a heavy metal should be used as 'light' metals such as aluminum generally have poorer step coverage.

In principle it is possible to make the second interconnect layer 214 by ink-jet printing of a liquid metal, or solution containing metal particles, which may save an additional mask step.

In principle it is also possible to define the second interconnect layer **214** by evaporating or sputtering a metal through a shadow mask. Optionally, the material is deposited under an angle that changes in time in order to improve step coverage.

Optionally, a protective layer (not shown in **FIG. 2**) can also be printed on top of the organic conductor. The protective layer may preferably comprise materials such as polystyrene, polynorbornene, PMMA, polycarbonate, and polyimides. The protective layer provides additional protection of the structure and increased mechanical robustness. For a display arrangement, the protective layer is preferably substantially transparent.

Stack integrity may be protected by, for example, assuring that, during solution deposition of subsequent semiconductor, insulator and/or conducting layers the underlying layer should not be dissolved, or swelled by the solvent used for the deposition of the subsequent layers. For this purpose an "orthogonal solvent system" in which solvents are chosen for each layer which have a solubility parameter that is incompatible with a previous layer, may be used.

The shape of the cavity is chosen with regard to, among other things, maintaining registration between layers and avoiding a leakage path.

In a preferred embodiment, the source **302** and drain **304** electrodes are provided as a pair of interdigitated electrodes. Each electrode has fingers that are oriented substantially parallel. These fingers extend in a first direction **315**. The semiconductor and insulator and gate **101**, **212** are then positioned such that their perpendicular projection overlaps the fingers and extends substantially in the first direction **315**, but does not overlap the ends of the electrode fingers. The projection of the gate **101**, **212** has an overlap with all the fingers of the source **302** and drain **304** electrodes; i.e. it extends in a second direction **316** (that is generally substantially perpendicular to the first direction) beyond the fingers. This structure is particularly advantageous for transistors with a normally on, e.g. p-type, semiconductor material. In that case, the organic semiconductor already carries charge carriers from source to drain and/or vice versa when the applied voltage on the gate-electrode is zero volt. An extension beyond the gate leads to a leakage path between source and drain electrode, since the transport of charge carriers cannot be interrupted or prevented by a gate voltage if no gate is overlapping this area. The gate electrode, preferentially, covers the inside of the cavity.

In this embodiment, the cavity, as seen from above, preferably, has rounded edges. A cavity with rounded edges is filled more easily than one with straight edges.

In the first direction **315** the projection of the cavity on the gate is limited within the edges of the gate-electrode **212**.

In the second direction **316** the projection of the cavity extends preferably beyond the edges of the gate-electrode **212**.

As explained above, the projection of the cavity on the gate being entirely within the edges of the gate electrode **212** in the first direction **315** assures, particularly for transistors with a p-type semiconductor material, that the organic semiconductor can carry charge carriers from source to drain and/or vice versa when the applied voltage on the gate-electrode is zero or higher. An extension beyond the gate leads to a leakage path between source and drain electrode, since there the transport of charge carriers cannot be interrupted.

Extension in the second direction **316** is preferred. If not present, a small deviation in the overlay between the cavity and the underlying layers has negative impact on the transistor characteristics. This is particularly the case if the transistor is part of the display. The overlay mismatch has then a negative effect on the display quality (directly). Furthermore, this extension opens the possibility to connect the polymer gate electrode to the second metallic interconnect lines outside the active TFT area. This may be useful when deposition (and patterning) of the second metal layer degrades the semiconductor layer underneath.

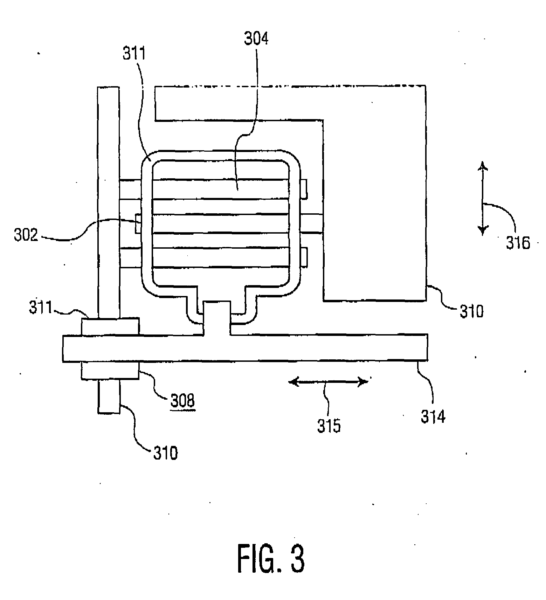

As can be seen from **FIG. 2** and **FIG. 3**, there is no leakage path in the crossing **208**, **308** between the two conductive layers. A crossing which includes a semiconductor layer between two conductive layers which is, for example, a disadvantage of the three mask process disclosed in non-prepublished application WO IB 2004/050669, filed May 13, 2004, is avoided by the present invention. This structure has the additional advantage, that the two conductive layers are separated by a distance formed by the barrier, and not by the thickness of the gate dielectric. Hence, processing of gate dielectric and resist structure can be optimized independently with regard to thickness. Step coverage is still a concern and may require special measures.

As can be seen from the above, the present invention permits a hybrid manufacturing process using lower definition patterning processes for self-aligned layers and avoiding the use of more expensive and difficult higher definition processes. Use, for example, of photolithography can advantageously be limited to a first layer of source and drain electrodes and a second layer of resist.

Suitable electrically conducting materials for forming the source, drain and gate electrodes include gold, paladium, platinum and other (noble) metals, oxidic conductors, such as ITO, polymeric conductors such as polyaniline and polyethylenedioxythiophene (PEDOT), particularly in combination with a polyacid. For n-type semiconductor it is possible to use metals with lower work function besides the metals already mentioned for p-type semiconductors.

Suitable gate dielectrics include all kinds of organic insulators, and in principle also inorganic insulators, such as sol-gel glasses.

The substrate may be of any suitable material. Polymeric materials suitable for use as substrates include, but are not limited to, polycarbonate (PC), polyethersulfon (PES), polynorbonene (PNB), polyarylate (PAR), polyethylene terephthalate (PET), polyethernafthalate (PEN), epoxide, polymethylmethacrylate (PMMA), polyurethane (PUR). Different materials may be suited for different uses and are known to one skilled in the art. The substrate may be of an organic compound, or an at least partly inorganic compound arranged with a organic surface.

The present invention is not limited to TFTs. Other semiconducting devices may be formed in structure and method of the present invention. The term "semiconducting device" as used herein refers to a conductor made with semiconducting material and includes, for example, a semiconductor unit, a conductor, a capacitor, a microchip, a crystal rectifier, a junction rectifier, a semiconductor diode, solar cells, an n-type semiconductor, a p-type semiconductor, a thermal resistor or thermistor, and a transistor, including an electronic, field-effect, thin-film field-effect or junction transistor, logic gates such as inverters, ring oscillators and integrated circuits such as shift registers.

In interpreting the appended claims, it should be understood that:
a) the word "comprising" does not exclude the presence of other elements or acts than those listed in a given claim;
b) the word "a" or "an" preceding an element does not exclude the presence of a plurality of such elements;
c) any reference numerals in the claims are for illustration purposes only and do not limit their protective scope; and
d) several "means" may be represented by the same item, structure or function.

## Claims

1. A method of manufacturing a transistor, the method comprising:
applying on a substrate (106, 206) a first layer (210) of a first conducting material in a pattern comprising a first interconnect layer and one or more source (302) and drain (304) electrodes;
forming a cavity on the substrate (106, 206), the cavity being formed of one or more walls extending from the substrate (106, 206);
coating all or part of an area in the cavity with a solution comprising a semiconductor or semiconductor precursor;
coating all or part of the area in the cavity with a gate insulator (213);
coating all or part of the area in the cavity with a second conducting material comprising a gate electrode (212);
and applying on the substrate (106, 206) a layer of a third conducting material in a pattern comprising a second interconnect layer (214, 314),
**characterized in that** the cavity is formed after the first layer (210) is applied to the substrate and that the ends of a source (302) and the ends of a drain (304) electrode extend outside the area in the cavity.

2. The method of claim 1 wherein the step of forming a pattern of one or more cavities on the substrate (106, 206) comprises depositing a resist.

3. The method of claim 1 wherein the step of applying the first layer (210) further comprises applying the pattern by lithography.

4. The method of claim 1 wherein one or more of the steps of coating all or part of the area in the cavity with the semiconductor or semiconductor precursor, coating all or part of an area in the cavity with the gate insulator, coating all or part of the area in the cavity with the second conducting material, or applying the layer of a third conducting material comprises ink-jet printing.

5. The method of claim 1 wherein the step of forming a cavity comprises forming the cavity with rounded edges, rounded corners or a concave wall.

6. The method of claim 1 wherein the step of forming a cavity comprises forming the cavity with at least one of the one or more walls having a side tapered to make the at least one of the walls narrow in a direction substantially perpendicular from a surface of the substrate.

7. The method of claim 1, further comprising a step of surface treatment after the step of applying the first layer of the first conducting material, after the step of forming the cavity or after the step of coating all or part of the area in the cavity with a solution comprising a semiconductor or semiconductor precursor.

8. The method of claim 1 wherein the step of coating all or part of an area in the cavity with a solution comprising a semiconductor or semiconductor precursor comprises depositing the semiconductor or semiconductor precursor in a thickness, after drying, of 100-200 nm.

9. The method of claim 1 wherein the step of coating all or part of the area in the cavity with a gate insulator (213) comprises coating all or part of the area in the cavity with a soluble gate insulator.

10. The method of claim 9 wherein the step of coating all or part of the area in the cavity with a soluble gate insulator, comprises depositing the soluble gate insulator in a thickness of 50-400 nm thick after drying.

11. The method of claim 1 wherein the second conducting material comprises a soluble polymer conductor.

12. The method of claim 11 wherein the second conducting material is applied to form a thickness of at least 50 nm after drying.

13. The method of claim 1 wherein the step of forming the cavity further comprises forming a barrier on the substrate.

14. The method of claim 13 wherein the step of applying a second conducting material comprises applying an interconnect line of the conducting material to the barrier.

15. The method of claim 13 wherein the step of forming the barrier comprises depositing the barrier in a thickness of 2 to 5 µm.

16. The method of claim 13 wherein the step of forming the barrier comprises forming the barrier to have a concave surface.

17. An electronic device comprising one or more transistors on a substrate (106, 206) and a connection of one or more of the transistors (207) to another of the transistors or to an output terminal, the one or more of the transistors (207) and at least part of the connection being provided in a structure comprising:
a substrate (106, 206);
a patterned first layer (210, 310) of a first conducting material applied on the substrate; and
a cavity comprising one or more walls on the substrate (106, 206), the one or more walls enclosing in a direction parallel to a surface of the substrate an area on the substrate (106, 206) and a part of the patterned first layer (210, 310),
the area having one or more layers of conductive, semiconductor and dielectric material,
**characterized by** the cavity comprising one or more walls being formed on the substrate (106, 206) that is provided with the patterned first layer (210, 310) and in that the ends of a source (302) and the ends of a drain (304) electrode formed in the patterned first layer (210, 310) extend outside the area in the cavity.

18. The electronic device of claim 17, wherein one of the one or more layers is a semiconductor material.

19. The electronic device of claim 17, wherein the semiconductor material is an organic semiconductor material.

20. The electronic device of claim 17, wherein the substrate is a polymeric material.

21. The electronic device of claim 17, wherein the cavity is formed from a resist.

22. The electronic device of claim 17, wherein one of the one or more walls of the cavity is concave.

23. The electronic device of claim 17, wherein one of the one or more walls of the cavity tapers to become more narrow in a direction substantially perpendicular from a surface of the substrate.

24. The electronic device of claim 17, wherein a barrier consisting of a resist is formed on the substrate (106, 206) and the patterned first layer (210), the barrier being at a crossing (308) between a first pattern of the first layer (210) of a first conducting material and a second pattern of a second layer (214) of the first conducting material or of a second conducting material.

25. The electronic device of claim 17, wherein a barrier comprising resist and tapering in a direction perpendicular to a surface of the substrate is formed on the substrate (106, 206) and the patterned first layer (210).

## Patentansprüche

1. Verfahren zum Herstellen eines Transistors mit folgenden Schritten:
Aufbringen einer ersten Schicht (210) eines ersten leitfähigen Materials in einem Muster, welches eine erste Verbindungsschicht und eine oder mehrere Source-Elektroden (302) und Drain-Elektroden (304) umfasst, auf einem Substrat (106, 206);
Ausbilden eines Hohlraums auf dem Substrat (106, 206), wobei der Hohlraum aus einer oder mehreren Wänden, welche sich von dem Substrat (106, 206) aus erstrecken, ausgebildet wird;
Beschichten eines Bereichs oder eines Teils eines Bereichs in dem Hohlraum mit einer Lösung, welche einen Halbleiter oder einen Halbleiter-Präkursor umfasst;
Beschichten des Bereichs oder eines Teils des Bereichs in dem Hohlraum mit einem Gate-Isolator (213);
Beschichten des Bereichs oder eines Teils des Bereichs in dem Hohlraum mit einem zweiten leitfähigen Material, welches eine Gate-Elektrode (212) umfasst; und
Aufbringen einer Schicht eines dritten leitfähigen Materials in einem Muster, welches eine zweite Verbindungsschicht (214, 314) umfasst, auf dem Substrat (106, 206);
**dadurch gekennzeichnet, dass** der Hohlraum ausgebildet wird, nachdem die erste Schicht (210) auf das Substrat aufgebracht wird, und dass die Enden einer Source-Elektrode (302) und die Enden einer Drain-Elektrode (304) sich nach außerhalb des Bereichs in dem Hohlraum erstrecken.

2. Verfahren nach Anspruch 1, bei welchem der Schritt des Ausbildens eines Musters eines oder mehrerer Hohlräume auf dem Substrat (106, 206) das Ablagern eines Fotolacks umfasst.

3. Verfahren nach Anspruch 1, bei welchem der Schritt des Aufbringens der ersten Schicht (210) das Aufbringen des Musters mittels Lithographie umfasst.

4. Verfahren nach Anspruch 1, bei welchem einer oder mehrere der Schritte des Beschichtens des Bereichs in dem Hohlraum oder eines Teils davon mit dem Halbleiter oder Halbleiter-Präkursor, des Beschichtens eines Bereichs in dem Hohlraum oder eines Teils davon mit dem Gate-Isolator, des Beschichtens des Bereichs in dem Hohlraum oder eines Teils davon mit dem zweiten leitfähigen Material oder des Aufbringens der Schicht eines dritten leitfähigen Materials das Tintenstrahldrucken umfasst.

5. Verfahren nach Anspruch 1, bei welchem der Schritt des Ausbildens eines Hohlraums das Ausbilden des Hohlraums mit abgerundeten Kanten, abgerundeten Ecken oder einer konkaven Wand umfasst.

6. Verfahren nach Anspruch 1, bei welchem der Schritt des Ausbildens eines Hohlraums das Ausbilden des Hohlraums mit wenigstens einer der zumindest einen Wand mit einer geneigten Seite umfasst, so dass die wenigstens eine Wand sich in einer Richtung, welche im Wesentlichen senkrecht zu einer Oberfläche des Substrats verläuft, verjüngt.

7. Verfahren nach Anspruch 1 mit dem Schritt einer Oberflächenbehandlung nach dem Schritt des Aufbringens der ersten Schicht des ersten leitfähigen Materials, nach dem Schritt des Ausbildens des Hohlraums oder nach dem Schritt des Beschichtens des gesamten Bereichs in dem Hohlraum oder eines Teils davon mit einer einen Halbleiter oder einen Halbleiter-Präkursor umfassenden Lösung.

8. Verfahren nach Anspruch 1, bei welchem der Schritt des Beschichtens eines gesamten Bereichs in dem Hohlraum oder eines Teils davon mit einer Lösung, welche einen Halbleiter oder einen Halbleiter-Präkursor umfasst, das Abscheiden des Halbleiters oder Halbleiter-Präkursors in einer Dicke nach dem Trocknen von 100 bis 200 nm umfasst.

9. Verfahren nach Anspruch 1, bei welchem der Schritt des Beschichtens des gesamten Bereichs in dem Hohlraum oder eines Teils davon mit einem Gate-Isolator (213) das Beschichten des gesamten Bereichs in dem Hohlraum oder eines Teils davon mit einem lösbaren Gate-Isolator umfasst.

10. Verfahren nach Anspruch 9, bei welchem der Schritt des Beschichtens des gesamten Bereichs in dem Hohlraum oder eines Teils davon mit einem lösbaren Gate-Isolator das Abscheiden des lösbaren Gate-Isolators in einer Dicke von 50 bis 400 nm nach dem Trocknen umfasst.

11. Verfahren nach Anspruch 1, bei welchem das zweite leitfähige Material einen löslichen Polymer-Leiter umfasst.

12. Verfahren nach Anspruch 11, bei welchem das zweite leitfähige Material in einer Dicke von wenigstens 50 nm nach dem Trocknen aufgebracht wird.

13. Verfahren nach Anspruch 1, bei welchem der Schritt des Ausbildens des Hohlraums das Ausbilden einer Barriere auf dem Substrat umfasst.

14. Verfahren nach Anspruch 13, bei welchem der Schritt des Aufbringens eines zweiten leitfähigen Materials das Aufbringen einer Verbindungsleitung des leitfähigen Materials auf die Barriere umfasst.

15. Verfahren nach Anspruch 13, bei welchem der Schritt des Ausbildens der Barriere das Abscheiden der Barriere in einer Dicke von 2 bis 5 µm umfasst.

16. Verfahren nach Anspruch 13, bei welchem der Schritt des Ausbildens der Barriere das Ausbilden der Barriere mit einer konkaven Oberfläche umfasst.

17. Elektronisches Bauelement mit einem oder mehreren Transistoren auf einem Substrat (106, 206) und mit einer Verbindung des einen oder mehrerer der Transistoren mit einem weiteren der Transistoren oder mit einem Ausgangsanschluss, wobei der eine Transistor oder die mehreren Transistoren (207) und wenigstens ein Teil der Verbindung in einer Struktur vorliegen, welche umfasst:
ein Substrat (106, 206);
eine strukturierte erste Schicht (210, 310) eines ersten leitfähigen Materials, welches auf dem Substrat aufgebracht ist; und
einen Hohlraum, welcher eine oder mehrere Wände auf dem Substrat (106, 206) umfasst, wobei die eine oder die mehreren Wände in einer Richtung parallel zu einer Oberfläche des Substrats einen Bereich auf dem Substrat (106, 206) und einen Teil der strukturierten ersten Schicht (210, 310) umschließen, wobei der Bereich einen oder mehrere Schichten eines leitfähigen, dielektrischen Halbleitermaterials umfasst,
**dadurch gekennzeichnet, dass** der Hohlraum, welcher einen oder mehrere Wände umfasst, auf dem mit der strukturierten ersten Schicht (210, 310) ausgebildeten Substrat (106, 206) ausgebildet ist, sowie **dadurch**, dass die Enden einer Source-Elektrode (302) und die Enden einer Drain-Elektrode (304), welche in der strukturierten ersten Schicht (210, 310) ausgebildet sind, sich nach außerhalb des Bereichs in dem Hohlraum erstrecken.

18. Elektronisches Bauelement nach Anspruch 17, bei welchem eine der einen oder mehreren Schichten ein Halbleitermaterial ist.

19. Elektronisches Bauelement nach Anspruch 17, bei welchem das Halbleitermaterial ein organisches Halbleitermaterial ist.

20. Elektronisches Bauelement nach Anspruch 17, bei welchem das Substrat ein polymerisches Material ist.

21. Elektronisches Bauelement nach Anspruch 17, bei welchem der Hohlraum aus einem Fotolack ausgebildet ist.

22. Elektronisches Bauelement nach Anspruch 17, bei welchem eine der einen oder mehreren Wände des Hohlraums konkav ist.

23. Elektronisches Bauelement nach Anspruchs 17, bei welchem eine der einen oder mehreren Wände des Hohlraums sich verjüngt, so dass sie in einer Richtung, welche im Wesentlichen senkrecht zu einer Oberfläche des Substrats verläuft, schmäler wird.

24. Elektronisches Bauelement nach Anspruch 17, bei welchem eine aus einem Fotolack bestehende Barriere auf dem Substrat (106, 206) und der strukturierten ersten Schicht (210) ausgebildet ist, wobei die Barriere an einer Kreuzung (308) zwischen einem ersten Muster der ersten Schicht (210) eines ersten leitfähigen Materials und einem zweiten Muster einer zweiten Schicht (214) des ersten leitfähigen Materials oder eines zweiten leitfähigen Materials liegt.

25. Elektronisches Bauelement nach Anspruch 17, bei welchem eine Barriere, welche einen Fotolack umfasst und sich in einer Richtung senkrecht zu einer Oberfläche des Substrats verjüngt, auf dem Substrat (106, 206) und der strukturierten ersten Schicht (210) ausgebildet ist.

## Revendications

1. Procédé de fabrication d'un transistor, le procédé comprenant :
l'application sur un substrat (106, 206) d'une première couche (210) d'un premier matériau conducteur dans un motif comprenant une premier couche d'interconnexion et une ou plusieurs électrodes de source (302) et de drain (304) ;
la formation d'une cavité sur le substrat (106, 206), la cavité étant formée d'une ou de plusieurs parois s'étendant depuis le substrat (106, 206) ;
le revêtement de tout ou partie d'une zone dans la cavité avec une solution comprenant un semi-conducteur ou un précurseur semi-conducteur ;
le revêtement de tout ou partie de la zone dans la cavité avec un isolant de grille (213) ;
le revêtement de tout ou partie de la zone dans la cavité avec un second matériau conducteur comprenant une électrode de grille (212) ;
et l'application sur le substrat (106, 206) d'une couche d'un troisième matériau conducteur dans un motif comprenant une seconde couche interconnectée (214, 314) ;
**caractérisé en ce que** la cavité est formée après que la première couche (210) est appliquée sur le substrat et **en ce que** les extrémités d'une électrode de source (302) et les extrémités d'une électrode de drain (304) s'étendent en dehors de la zone dans la cavité.

2. Procédé selon la revendication 1, dans lequel l'étape de formation d'un motif d'une ou de plusieurs cavités sur le substrat (106, 206) comprend en outre le dépôt d'un résist.

3. Procédé selon la revendication 1, dans lequel l'étape d'application de la première couche (210) comprend en outre l'application du motif par lithographie.

4. Procédé selon la revendication 1, dans lequel les une ou plusieurs étapes de revêtement de tout ou partie de la zone dans la cavité avec le semi-conducteur ou précurseur semi-conducteur, de revêtement de tout ou partie de la zone dans la cavité avec l'isolant de grille, de revêtement de tout ou partie de la zone dans la cavité avec le second matériau conducteur ou d'application de la couche d'un troisième matériau conducteur comprend une impression à jet d'encre.

5. Procédé selon la revendication 1, dans lequel l'étape de formation d'une cavité comprend la formation de la cavité avec des bords arrondis, des coins arrondis ou une paroi concave.

6. Procédé selon la revendication 1, dans lequel l'étape de formation d'une cavité comprend la formation de la cavité dont au moins l'une des une ou plusieurs parois a un côté conique afin de faire en sorte que l'au moins une des parois soit rétrécie dans un sens sensiblement perpendiculaire à une surface du substrat.

7. Procédé selon la revendication 1, comprenant en outre une étape de traitement de surface après l'étape d'application de la première couche du premier matériau conducteur, après l'étape de formation de la cavité ou après l'étape de revêtement de tout ou partie de la zone dans la cavité avec une solution comprenant un semi-conducteur ou précurseur semi-conducteur.

8. Procédé selon la revendication 1, dans lequel l'étape de revêtement de tout ou partie d'une zone dans la cavité avec une solution comprenant un semi-conducteur ou un précurseur semi-conducteur comprend le dépôt du semi-conducteur ou précurseur semi-conducteur sur une épaisseur, après séchage, de 100 à 200 nm.

9. Procédé selon la revendication 1, dans lequel l'étape de revêtement de tout ou partie de la zone dans la cavité avec un isolant de grille (213) comprend le revêtement de tout ou partie de la zone dans la cavité avec un isolant de grille soluble.

10. Procédé selon la revendication 9, dans lequel l'étape de revêtement de tout ou partie de la zone dans la cavité avec un isolant de grille soluble comprend le dépôt de l'isolant de grille soluble sur une épaisseur de 50 à 400 nm après séchage.

11. Procédé selon la revendication 1, dans lequel le second matériau conducteur comprend un conducteur polymère soluble.

12. Procédé selon la revendication 11, dans lequel le second matériau conducteur est appliqué pour former une épaisseur d'au moins 50 nm après séchage.

13. Procédé selon la revendication 1, dans lequel l'étape de formation de la cavité comprend en outre la formation d'une barrière sur le substrat.

14. Procédé selon la revendication 13, dans lequel l'étape d'application d'un second matériau conducteur comprend l'application d'une ligne d'interconnexion du matériau conducteur jusqu'à la barrière.

15. Procédé selon la revendication 13, dans lequel l'étape de formation de la barrière comprend le dépôt de la barrière sur une épaisseur de 2 à 5 µm.

16. Procédé selon la revendication 13, dans lequel l'étape de formation de la barrière comprend la formation de la barrière de façon à ce qu'elle ait une surface concave.

17. Dispositif électronique comprenant un ou plusieurs transistors sur un substrat (106, 206) et une connexion d'un ou plusieurs des transistors (207) à un autre des transistors ou à une borne de sortie, les un ou plusieurs des transistors (207) et au moins une partie de la connexion étant disposés dans une structure comprenant :
un substrat (106, 206) ;
une première couche à motif (210, 310) d'un premier matériau conducteur appliqué sur le substrat ; et
une cavité comprenant une ou plusieurs parois sur le substrat (106, 206), les une ou plusieurs parois enfermant dans un sens parallèle à la surface du substrat une zone sur le substrat (106, 206) et une partie de la première couche à motif (210, 310),
la zone ayant une ou plusieurs couches de matériau conducteur, diélectrique ou semi-conducteur,
**caractérisé par le fait que** la cavité comprenant une ou plusieurs parois est formée sur le substrat (106, 206) doté de la première couche à motif (210, 310) et en ce que les extrémités d'une électrode de source (302) et les extrémités d'une électrode de drain (304) formées dans la première couche à motif (210, 310) s'étendent en dehors de la zone dans la cavité.

18. Dispositif d'électrode selon la revendication 17, dans lequel une des une ou plusieurs couches est un matériau semi-conducteur.

19. Dispositif d'électrode selon la revendication 17, dans lequel le matériau semi-conducteur est un matériau semi-conducteur organique.

20. Dispositif d'électrode selon la revendication 17, dans lequel le substrat est un matériau polymérique.

21. Dispositif d'électrode selon la revendication 17, dans lequel la cavité est formée à partir d'un résist.

22. Dispositif d'électrode selon la revendication 17, dans lequel l'une des une ou plusieurs parois de la cavité est concave.

23. Dispositif d'électrode selon la revendication 17, dans lequel l'une des une ou plusieurs parois de la cavité est conique afin de devenir plus étroite dans un sens sensiblement perpendiculaire à une surface du substrat.

24. Dispositif d'électrode selon la revendication 17, dans lequel une barrière consistant en un résist est formée sur le substrat (106, 206) et la première couche à motif (210), la barrière se trouvant à un croisement (308) entre un premier motif de la première couche (210) d'un premier matériau conducteur et un second motif d'une seconde couche (214) du premier matériau conducteur ou d'un second matériau conducteur.

25. Dispositif d'électrode selon la revendication 17, dans lequel une barrière comprenant un résist et une conicité dans un sens perpendiculaire à une surface du substrat est formée sur le substrat (106, 206) et la première couche à motif (210).
